# EUROPEAN PATENT SPECIFICATION

(11) **EP 3 104 388 B1**
(45) Date of publication and mention of the grant of the patent: **29.04.2020**
(21) Application number: 16173880.2
(22) Date of filing: 10.06.2016
(51) Int. Cl.: H01H 9/16, H03K 17/96, H01H 13/14, H01H 13/02

(54) **INPUT DEVICE**
EINGABEVORRICHTUNG
DISPOSITIF D'ENTREE

(30) Priority: 11.06.2015 JP 2015118433
(43) Date of publication of application: 14.12.2016
(73) Proprietor: Alps Alpine Co., Ltd., Tokyo 145-8501 (JP)
(72) Inventor: Takahashi, Akihiro, Tokyo, Tokyo 145-8501 (JP); Kobayashi, Kotaro, Tokyo, Tokyo 145-8501 (JP); Toyama, Atsushi, Tokyo, Tokyo 145-8501 (JP)
(74) Representative: Schmitt-Nilson Schraud Waibel Wohlfrom Patentanwälte Partnerschaft mbB

(56) References cited:
- DE-A1-102005 025 021
- DE-A1-102009 041 653
- DE-U1-202013 011 516
- US-A1- 2009 107 829
- US-A1- 2011 042 196
- US-A1- 2012 161 795

## Description

### CLAIM OF PRIORITY

This application claims benefit of Japanese Patent Application No. 2015-118433 filed on June 11, 2015.

### BACKGROUND OF THE INVENTION

### 1. Field of the Invention

The present invention relates to an input device having an illumination function.

### 2. Description of the Related Art

There is known a switch with a capacitance sensor that detects the change in capacitance when an operator touches an operation surface that includes a detection electrode formed of a metal plate. There is a demand for the improvement of operability through the illumination of a display portion that is provided on the operation surface of such a switch.

A case in which a transparent electrode is used as the detection electrode instead of the metal plate is considered to meet the above-mentioned demand, but there is a problem that the use of the transparent electrode causes cost to increase.

### SUMMARY OF THE INVENTION

The invention has been made in consideration of the above-mentioned circumstances, and provides an electrostatic capacitance type input device that can realize an illumination function by a simple and inexpensive structure.

US 2012/0161795 A1 discloses an input device according to the preamble of claim 1.

DE 10 2009 041653 A1 describes a capacitive sensing device for generating a switching signal upon approach and / or contact a plate-like sensor element by a user. A shift range of electrically conductive material is arranged on a user side facing away from a dielectric material sensor element, arranged at side remote from the user side.

DE 10 2005 025021 A1 relates to a switch element for actuating a switching function in a vehicle, wherein in the switch element a proximity sensor is integrated, with the approach of the actuating element to the switching element, in particular the approach of a finger, can be detected.

US 2011/042196 A1 discloses a push switch including an operating member, a holding member, a detecting electrode including a plate-shaped spring, a conductive coil spring, and a wiring substrate. The operating member includes a top portion. The rear surface of the top portion and the holding member define a storage space.

In order to solve the above-mentioned problem, an input device according to an aspect of the invention includes an electrode section configured to form coupling capacitance between an operating body and itself, and a light-emitting unit. The electrode section is positioned between the light-emitting unit and the operating body and forms a light passage through which light emitted from the light-emitting unit toward the operating body passes.

According to this structure, the electrode section is positioned between the light-emitting unit and the operating body, coupling capacitance between the operating body and the electrode section is changed when the operating body is close to the electrode section, and it is possible to detect whether or not the operating body is close to the electrode section through the detection of the change in the coupling capacitance. Further, according to this structure, the electrode section forms the light passage through which light emitted from the light-emitting unit toward the operating body passes. Accordingly, even though an expensive transparent electrode is not used as the electrode section, it is possible to guide the light, which is emitted from the light-emitting unit, to the operating body through the light passage. That is, an illumination function can be realized by an inexpensive structure.

The electrode section of the input device according to the aspect of the invention is formed in the shape of a tube that includes an opening formed at a portion of the light passage close to the operating body.

According to this structure, since the electrode section is formed in the shape of a tube that is relatively easily worked, it is possible to inexpensively form the light passage through which the light emitted from the light-emitting unit toward the operating body passes.

Preferably, the input device according to the aspect of the invention further includes an operation section which is positioned on a side of the electrode section opposite to the light-emitting unit so as to face the opening and which the operating body comes into contact with or comes close to, and an inner surface of a hollow portion of the electrode section extends from the opening toward the light-emitting unit.

According to this structure, it is possible to detect whether the operating body is in contact with or is close to the operation section on the basis of capacitive coupling between the operating body and the electrode section. Further, since the inner surface of the hollow portion of the electrode section extends from the opening toward the light-emitting unit, sufficient capacitive coupling can be generated between the operating body and the inner surface even though the electrode section is provided with the opening forming the light passage.

The input device according to the invention further includes a light guiding section that is interposed between the light-emitting unit and the operation section and is configured to guide the light emitted from the light-emitting unit, and light emitted from the light guiding section is guided to the operation section through the opening of the electrode section.

According to this structure, since the light guiding section is provided, a relatively large region on the side of the operating body can be uniformly irradiated with the light emitted from the light-emitting unit. Accordingly, it is possible to suppress the variation of the illuminance of a display pattern.

Preferably, the input device according to the aspect of the invention further includes a switch, and the operation section is moved in a direction of a pressing operation directed to the light-emitting unit according to the pressing operation and performs an operation for switching the switch at a predetermined position in the pressing direction.

According to this structure, it is possible to perform a switching operation according to a pressing operation of the operation section in addition to a function to detect whether the operating body is in contact with or is close to the operation section on the basis of the capacitive coupling between the operating body and the electrode section.

Preferably, the input device according to the aspect of the invention further includes an elastic member that is configured to generate an elastic force in the direction of the pressing operation of the operation section, and the operation section is moved in the pressing direction against the elastic force of the elastic member according to the pressing operation.

Preferably, the electrode section of the input device according to the aspect of the invention is moved in the direction of the pressing operation while interlocking with the movement of the operation section in the pressing direction, and one end of the conductive elastic member is fixed to the electrode section.

According to this structure, since the change in the coupling capacitance between the operating body and the electrode section can be transmitted through the elastic member, a structure for detecting the change in the coupling capacitance can be easily constructed.

Preferably, in the input device according to the aspect of the invention, the thickness of the electrode section and the length of the electrode section in a direction where light passes through the light passage are prescribed so that detection sensitivity of the operating body is made uniform in a certain region of an operation surface of the operation section.

According to this structure, since the detection sensitivity of the operating body can be made uniform in a certain region of the operation surface of the operation section, high detection accuracy is obtained.

Preferably, the electrode section of the input device according to the aspect of the invention is made of metal. According to this structure, an expensive transparent electrode does not need to be used and an illumination function can be inexpensively realized.

According to the aspect of the invention, it is possible to provide an electrostatic capacitance type input device that can realize an illumination function by a simple and inexpensive structure.

### BRIEF DESCRIPTION OF THE DRAWINGS

Fig. 1 is a view showing the appearance of an input device according to an embodiment of the invention;
Fig. 2 is an exploded perspective view of the input device shown in Fig. 1;
Fig. 3 is a view showing the input device shown in Figs. 1 and 2 from a substrate;
Fig. 4 is a cross-sectional view taken along line A-A shown in Fig. 1; and
Fig. 5 is a view showing the action of non-contact electrostatic sensing shown in Fig. 1.

### DESCRIPTION OF THE PREFERRED EMBODIMENTS

An input device according to an embodiment of the invention will be described below.

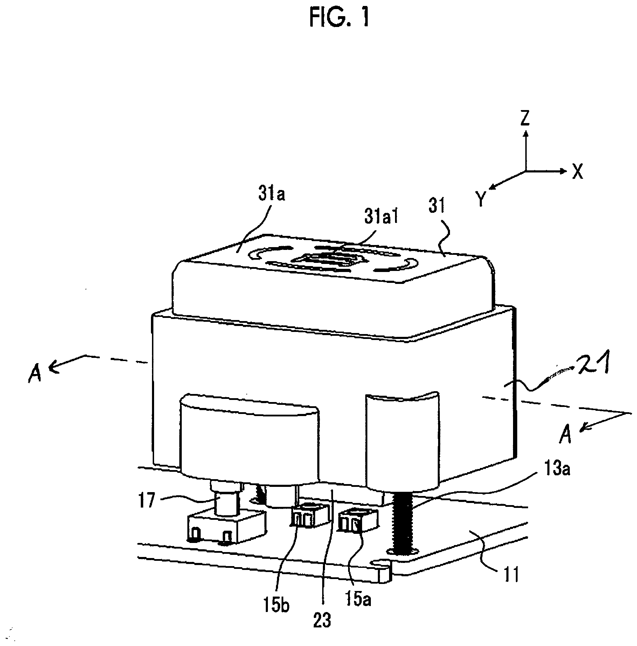

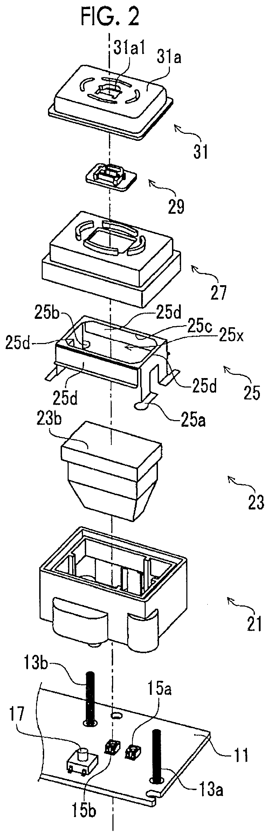

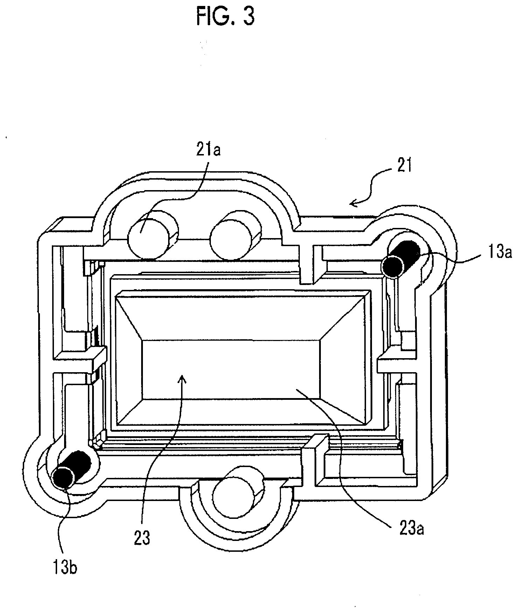

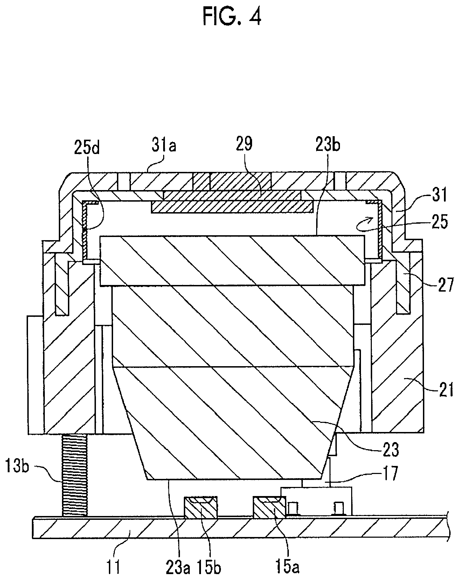

Fig. 1 is a view showing the appearance of the input device 1 according to the embodiment of the invention. Fig. 2 is an exploded perspective view of the input device 1 shown in Fig. 1. Fig. 3 is a view showing the input device 1 shown in Figs. 1 and 2 from a substrate 11. Fig. 4 is a cross-sectional view taken along line A-A shown in Fig. 1.

As shown in Fig. 1, in the input device 1, a base body 21, which is supported above a substrate 11 with elastic members 13a and 13b interposed therebetween, is provided with an operation section 31.

A cut-out portion 31a1 having a pattern of a predetermined sign or letter is formed on an operation surface 31a of the operation section 31, and the surface of a light guide section 29 is exposed to the outside through the cut-out portion 31a1. Light, which is emitted from light-emitting units 15a and 15b provided on the substrate 11, reaches the surface of the light guide section 29, and the surface of the light guide section 29 corresponding to the pattern is brightened.

The input device 1 has a function to detect whether an operating body 60, such as a finger, is in contact with or is close to the operation section 31 on the basis of the change in electrical characteristics according to electrostatic coupling, and a function to allow the base body 21 to perform the switching operation of a switch 17 by allowing the operation section 31 and the base body 21 to move integrally with each other toward the substrate 11 when the operation section 31 is pressed in a Z direction (the direction of a pressing operation) by the operating body 60.

As shown in Figs. 1 to 4, in the input device 1, one end of each of the elastic members 13a and 13b is fixed to the substrate 11 and the other end of each of the elastic members 13a and 13b is fixed to an electrode section 25 fixed to the base body 21.

Two light-emitting units 15a and 15b and a push-button switch 17 are provided on the substrate 11.

Further, as shown in Figs. 1 and 3, a light guiding section 23 is fixed to the electrode section 25 fixed to the base body 21. Specifically, the electrode section 25 is formed in the shape of a tube that forms a light passage 25x through which light emitted from the light-emitting units 15a and 15b toward the operation section 31 passes. The light guiding section 23 is fixed to the light passage 25x of the electrode section 25.

The light guiding section 23 faces the light-emitting units 15a and 15b, and includes a light incident surface 23a on which light emitted from the light-emitting units 15a and 15b is incident.

Furthermore, the light guiding section 23 includes a light emitting surface 23b that is provided at a position facing the operation section 31 opposite to the light incident surface 23a in the Z direction. The light incident surface 23a and the light emitting surface 23b are flat surfaces, but the area of the light emitting surface 23b is larger than that of the light incident surface 23a.

The light incident surface 23a of the light guiding section 23 is provided at a position projected toward the substrate 11 from the lower end portion of the base body 21, and the light emitting surface 23b is positioned in an opening 25c of the electrode section 25 so as to be close to the light incident surface 23a.

When the operation section 31 is moved in the Z direction (a pressing direction) in Fig. 1, the light guiding section 23 is moved integrally with the operation section 31 in the Z direction.

A pressing portion 21a, which faces the switch 17 and is formed of a flat surface, is provided on the surface of the base body 21 facing the substrate 11.

When the operation section 31 is moved in the Z direction (the pressing direction) in Fig. 1, the base body 21 is moved integrally with the operation section 31 in the Z direction. When the base body 21 is positioned at a predetermined position in the Z direction, the pressing portion 21a is in contact with the switch 17. When the operation section 31 is further pressed toward the substrate 11, the switch 17 is pressed by the pressing portion 21a and a switching operation is performed.

In the input device 1, the electrode section 25 is supported by the base body 21 so as to be movable in the Z direction in a state in which the electrode section 25 holds the light guiding section 23.

In this case, the other ends of the elastic members 13a and 13b are fixed to and electrically connected to contact pad portions 25a and 25b of the electrode section 25, respectively.

The electrode section 25 is formed in the shape of a tube that includes a substantially rectangular opening 25c formed at a portion thereof close to the operation section 31, and side wall portions 25d, which are positioned at four sides of the rectangular opening, extend in the Z direction. The contact pad portions 25a and 25b are provided at two corners, which are opposite to each other, of the side wall portions 25d.

One end of each of the elastic members 13a and 13b is electrically connected to a conductive pattern (not shown) formed on the substrate 11. When the operating body 60 is in contact with or is close to the operation section 31, electrostatic coupling is formed between the operating body 60 and the side wall portions 25d. Accordingly, the capacitance of the electrode section 25 is changed according to the electrostatic coupling, and the change in the capacitance of the electrode section 25 occurs on the conductive pattern through the elastic members 13a and 13b and is detected by a detection circuit (not shown) provided on the substrate 11.

The electrode section 25 is made of conductive metal and forms coupling capacitance between the operating body, such as a finger, which is in contact with or is close to the operation section 31, and itself.

The electrode section 25 is formed in the shape of a tube as described above, allows light emitted from the light-emitting units 15a and 15b to be incident on itself through the light guiding section 23 positioned in the light passage 25x, and emits the light to a receiving section 27 through the light emitting surface 23b that is positioned in the light passage 25x.

Since the electrode section 25 is formed in the above-mentioned shape of a tube, it is possible to guide the light, which is incident on the electrode section 25 from the light guiding section 23, to the operation section 31 and to form sufficient electrostatic coupling between the operating body 60 and the side wall portions 25d even though the opening 25c is formed at the portion of the electrode section 25 close to the operation section 31. For this reason, it is possible to sufficiently change capacitance by the presence/absence of the operating body 60 and to detect the presence/absence of the operating body 60 with high accuracy. That is, the electrode section 25 can have a sufficient area, which is required for capacitance, through the side wall portions 25d.

The thickness of the side wall portion 25d of the electrode section 25 and the length of the side wall portion 25d in the Z direction (the length of the side wall portion 25d in a direction where light passes through the light passage 25x) are prescribed so that the detection sensitivity of the operating body 60 is made uniform in a certain region of the operation surface 31a of the operation section 31.

According to this structure, the detection sensitivity of the operating body 60 can be made uniform in a certain region of the operation surface 31a. Accordingly, high detection accuracy is obtained.

Specifically, it is preferable that the height of the side wall portion 25d is adjusted to the same length as the length of the opening 25c in a lateral direction.

The receiving section 27 is fixed to the side of the electrode section 25 corresponding to the opening 25c.

The receiving section 27 is made of, for example, a non-transparent member, and an opening 27a is formed at a central portion of the receiving section 27.

The transparent or translucent light guide section 29 is mounted in the opening 27a. A pattern of a predetermined sign or letter is formed on the light guide section 29.

The operation section 31 is fixed to the receiving section 27 in a state in which the light guide section 29 is mounted on the receiving section 27.

The operation section 31 is provided with the cut-out portion 31a1 through which the light guide section 29 is exposed to the outside.

The action of the input device 1 will be described below.

### Illumination action

Light, which is emitted from the light-emitting units 15a and 15b toward the light guiding section 23, is incident on the light guiding section 23 from the light incident surface 23a, is diffused in the light guiding section 23, and is emitted toward the receiving section 27 from the light emitting surface 23b.

In this case, since the light guiding section 23 is positioned in the light passage 25x that is formed by the hollow portion of the electrode section 25, light emitted from the light-emitting units 15a and 15b is emitted to the receiving section 27 through the light passage 25x that is formed by the electrode section 25. That is, light emitted from the light-emitting units 15a and 15b is not blocked by the electrode section 25.

Further, the light incident on the receiving section 27 reaches the cut-out portion 31a1 of the operation surface 31a of the operation section 31 through the transparent light guide section 29 that is mounted on the receiving section 27.

Accordingly, an illumination function to illuminate the operation section 31 can be realized in the input device 1.

### Non-contact electrostatic sensing

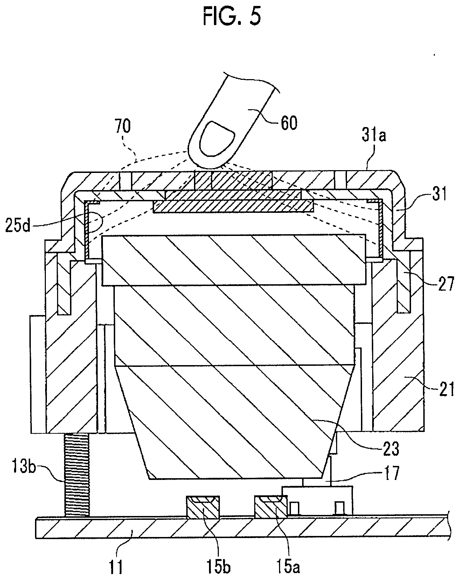

When the operating body 60, such as a finger, is in contact with or is close to the operation section 31 as shown in Fig. 5, the capacitance of the electrode section 25 is changed by the electrostatic coupling between the operating body 60 and the electrode section 25. In this case, since the side wall portions 25d of the electrode section 25 have a large area, sufficient electrostatic coupling is formed between the side wall portions 25d and the operating body 60. Accordingly, the capacitance of the electrode section 25 is changed.

The detection circuit provided on the substrate 11 detects the capacitance of the electrode section 25 through the elastic members 13a and 13b, and determines whether the operating body 60 is in contact with or is close to the operation section 31.

### Pressing operation

When the operation section 31 is pressed by the operating body 60, the base body 21 is moved integrally with the operation section 31 toward the substrate 11 in the Z direction (the pressing direction) in Fig. 1. Further, when the base body 21 is positioned at a predetermined position in the Z direction, the pressing portion 21a is in contact with the switch 17. When the operation section 31 is further pressed, the switch 17 is pressed by the pressing portion 21a and a switching operation is performed.

According to the input device 1, as described above, the electrode section 25 is positioned between the light-emitting units 15a and 15b and the operating body 60, the coupling capacitance between the operating body 60 and the electrode section 25 is changed when the operating body 60 is in contact with or is close to the operation section 31, and it is possible to determine whether the operating body 60 is in contact with or is close to the operation section 31 through the detection of the change in the coupling capacitance between the operating body 60 and the electrode section 25. Further, according to the input device 1, since the electrode section 25 forms the light passage 25x for the light emitted from the light-emitting units 15a and 15b, the light emitted from the light-emitting units 15a and 15b can be guided to the operation surface 31a of the operation section 31 through the light passage 25x even though an expensive transparent electrode is not used as the electrode section. That is, an illumination function can be realized by an inexpensive structure.

Furthermore, in the input device 1, the electrode section 25 is formed in the shape of a tube that is relatively easily worked. Accordingly, it is possible to inexpensively form the light passage 25x through which the light emitted from the light-emitting units 15a and 15b toward the operation section 31 passes.

Moreover, in the input device 1, the side wall portions 25d, which form the inner surface of the hollow portion of the electrode section 25, are formed so as to extend in the Z direction that is directed to the light-emitting units 15a and 15b from the opening 25c. For this reason, even though the electrode section 25 is provided with the opening 25c forming the light passage 25x, sufficient capacitive coupling can be generated between the operating body 60 and the side wall portions 25d.

Further, according to the input device 1, since the light guiding section 23 is provided, a relatively large region of the operation section 31 can be uniformly irradiated with the light emitted from the light-emitting units 15a and 15b. Accordingly, it is possible to suppress the variation of the illuminance of a display pattern.

According to the input device 1, since the base body 21 is supported by the elastic members 13a and 13b so as to be movable in the Z direction and a mechanism for turning on/off the switch 17 is provided, it is possible to perform a switching operation according to a pressing operation of the operation section 31 in addition to a function to detect whether the operating body 60 is in contact with or is close to the operation section 31 on the basis of the capacitive coupling between the operating body 60 and the side wall portions 25d.

According to the input device 1, since the change in the coupling capacitance between the operating body 60 and the electrode section 25 can be transmitted through the elastic members 13a and 13b, a structure for detecting the change in the coupling capacitance can be easily constructed.

Furthermore, in the input device 1, the electrode section 25 is made of metal. According to this structure, an expensive transparent electrode does not need to be used and an illumination function can be inexpensively realized.

The invention is not limited to the above-mentioned embodiment.

That is, those skilled in the art may allow the components of the above-mentioned embodiment to have various modifications, combinations, sub-combinations, and alterations within the scope of the claims.

For example, the input device 1 having a function to input a pressing operation in addition to non-contact electrostatic sensing has been exemplified in the above-mentioned embodiment, but the input device of the invention may not have the function to input a pressing operation.

Moreover, the shape of the operation section 31 and the pattern of the cut-out portion 31a1 to be illuminated are arbitrary, and the entire operation section 31 may be formed of a transparent or translucent member.

The invention can be applied to an electrostatic capacitance type input device having an illumination function.

## Claims

1. An input device (1) comprising:
an electrode section (25) configured to form coupling capacitance between an operating body (60) and itself; and
a light-emitting unit (15a, 15b),
wherein the electrode section (25) is positioned between the light-emitting unit (15a, 15b) and the operating body (60) and forms a light passage (25x) through which light emitted from the light-emitting unit (15a, 15b) toward the operating body (60) passes,
wherein the electrode section (25) is formed in the shape of a tube that includes an opening (25c) formed at a portion of the light passage (25x) close to the operating body (60),
the input device (1) further comprising:
a light guiding section (23) that is interposed between the light-emitting unit (15a, 15b) and an operation section (31) and is configured to guide the light emitted from the light-emitting unit (15a, 15b),
wherein light emitted from the light guiding section (23) is guided to the operation section (31) through the opening (25c) of the electrode section (25),
wherein the light guiding section (23) faces the light-emitting unit (15a, 15b), and includes a light incident surface (23a) on which light emitted from the light-emitting unit (15a, 15b) is incident,
wherein the light guiding section (23) includes a light emitting surface (23b) that is provided at a position facing the operation section (31) opposite to the light incident surface (23a),
**characterized in that**
a base body (21), which is supported above a substrate (11) with elastic members (13a, 13b) interposed therebetween, is provided with the operation section (31);
the light guiding section (23) is fixed to the electrode section (25),
the light incident surface (23a) and the light emitting surface (23b) are flat surfaces, and
an area of the light emitting surface (23b) is larger than that of the light incident surface (23a).

2. The input device (1) according to claim 1,
wherein the operation section (31) is positioned on a side of the electrode section (25) opposite to the light-emitting unit (15a, 15b) so as to face the opening (25c) and which the operating body (60) comes into contact with or comes close to,
wherein an inner surface of a hollow portion of the electrode section (25) extends from the opening (25c) toward the light-emitting unit (15a, 15b).

3. The input device (1) according to any one of claims 1 or 2, further comprising:
a switch (17),
wherein the operation section (31) is moved in a direction of a pressing operation directed to the light-emitting unit (15a, 15b) according to the pressing operation, and performs an operation for switching the switch (17) at a predetermined position in the pressing direction.

4. The input device (1) according to claim 3, further comprising:
an elastic member (13a, 13b) that is configured to generate an elastic force in the direction of the pressing operation of the operation section (31),
wherein the operation section (31) is moved in the pressing direction against the elastic force of the elastic member (13a, 13b) according to the pressing operation.

5. The input device (1) according to claim 4,
wherein the electrode section (25) is moved in the direction of the pressing operation while interlocking with the movement of the operation section (31) in the pressing direction, and
one end of the conductive elastic member (13a, 13b) is fixed to the electrode section (25).

6. The input device (1) according to any one of claims 1 to 5,
wherein the electrode section (25) is made of metal.

## Patentansprüche

1. Eingabevorrichtung (1), aufweisend:
einen Elektrodenbereich (25), der dazu ausgebildet ist, eine Kopplungskapazität zwischen einem Betätigungskörper (60) und sich selbst zu bilden; und
eine Lichtemissionseinheit (15a, 15b),
wobei der Elektrodenbereich (25) zwischen der Lichtemissionseinheit (15a, 15b) und dem Betätigungskörper (60) angeordnet ist und einen Lichtdurchgang (25x) bildet, durch den von der Lichtemissionseinheit (15a, 15b) emittiertes Licht in Richtung auf den Betätigungskörper (60) hindurchgeht,
wobei der Elektrodenbereich (25) in Form eines Rohrs ausgebildet ist, das eine Öffnung (25c) aufweist, die an einem in der Nähe des Betätigungskörpers (60) befindlichen Bereich des Lichtdurchgangs (25x) ausgebildet ist,
wobei die Eingabevorrichtung (1) ferner aufweist:
einen Lichtführungsbereich (23), der zwischen der Lichtemissionseinheit (15a, 15b) und einem Betätigungsbereich (31) angeordnet ist und dazu ausgebildet ist, das von der Lichtemissionseinheit (15a, 15b) emittierte Licht zu führen,
wobei von der Lichtemissionseinheit (23) emittiertes Licht durch die Öffnung (25c) des Elektrodenbereichs (25) zu dem Betätigungsbereich (31) geführt wird,
wobei der Lichtführungsbereich (23) der Lichtemissionseinheit (15a, 15b) zugewandt ist und eine Lichteinfallsfläche (23a) aufweist, auf der von der Lichtemissionseinheit (15a, 15b) emittiertes Licht einfällt,
wobei der Lichtführungsbereich (23) eine Lichtemissionsfläche (23b) aufweist, die an einer dem Betätigungsbereich (31) zugewandten Position gegenüber der Lichteinfallsfläche (23a) vorgesehen ist,
**dadurch gekennzeichnet,**
**dass** ein Basiskörper (21), der unter Zwischenanordnung von elastischen Elementen (13a, 13b) über einem Substrat (11) gehalten ist, mit dem Betätigungsbereich (31) versehen ist,
**dass** der Lichtführungsbereich (23) an dem Elektrodenbereich (25) festgelegt ist,
**dass** es sich bei der Lichteinfallsfläche (23a) und der Lichtemissionsfläche (23b) um ebene Flächen handelt, und
**dass** eine Oberfläche der Lichtemissionsfläche (23b) größer ist als die der Lichteinfallsfläche (23a).

2. Eingabevorrichtung (1) nach Anspruch 1,
wobei der Betätigungsbereich (31) auf einer der Lichtemissionseinheit (15a, 15b) gegenüberliegende Seite des Elektrodenbereichs (25) in der Öffnung (25c) zugewandter Weise angeordnet ist und der Betätigungskörper (60) mit diesem in Kontakt kommt oder diesem nahe kommt,
wobei sich eine Innenfläche eines hohlen Bereichs des Elektrodenbereichs (25) von der Öffnung (25c) in Richtung auf die Lichtemissionseinheit (15a, 15b) erstreckt.

3. Eingabevorrichtung (1) nach einem der Ansprüche 1 oder 2,
die ferner aufweist:
einen Schalter (17),
wobei der Betätigungsbereich (31) in Abhängigkeit von einer Drückbetätigung in einer Drückbetätigungsrichtung, die auf die Lichtemissionseinheit (15a, 15b) gerichtet ist, bewegt wird und einen Vorgang zum Schalten des Schalters (17) an einer vorbestimmten Position in der Drückbetätigungsrichtung ausführt.

4. Eingabevorrichtung (1) nach Anspruch 3,
die ferner aufweist:
ein elastisches Element (13a, 13b), das dazu ausgebildet ist, eine elastische Kraft in der Richtung der Drückbetätigung des Betätigungsbereichs (31) zu erzeugen,
wobei der Betätigungsbereich (31) in der Drückrichtung gegen die elastische Kraft des elastischen Elements (13a, 13b) entsprechend der Drückbetätigung bewegt wird.

5. Eingabevorrichtung (1) nach Anspruch 4,
wobei der Elektrodenbereich (25) in der Drückbetätigungsrichtung bewegt wird und dabei mit der Bewegung des Betätigungsbereichs (31) in der Drückrichtung gekoppelt ist, und
wobei ein Ende des leitfähigen elastischen Elements (13a, 13b) an dem Elektrodenbereich (25) festgelegt ist.

6. Eingabevorrichtung (1) nach einem der Ansprüche 1 bis 5,
wobei der Elektrodenbereich (25) aus Metall besteht.

## Revendications

1. Dispositif d'entrée (1) comprenant :
une section d'électrode (25) configurée de manière à former une capacité de couplage entre un corps de commande (60) et elle-même ; et
une unité électroluminescente (15a, 15b),
dans lequel la section d'électrode (25) est positionnée entre l'unité électroluminescente (15a, 15b) et le corps de commande (60) et forme un passage lumineux (25x) à travers lequel la lumière émise par l'unité électroluminescente (15a, 15b) passe en direction du corps de commande (60),
dans lequel la section d'électrode (25) a la forme d'un tube qui comprend une ouverture (25c) située au niveau d'une partie du passage lumineux (25x) proche du corps de commande(60),
le dispositif d'entrée (1) comprenant en outre :
une section de guidage de la lumière (23) qui est interposée entre l'unité électroluminescente (15a, 15b) et une section de commande (31) et qui est configurée de manière à guider la lumière émise par l'unité électroluminescente (15a, 15b),
dans lequel la lumière émise par la section de guidage de la lumière (23) est guidée vers la section de commande (31) à travers l'ouverture (25c) de la section d'électrode (25),
dans lequel la section de guidage de la lumière (23) fait face à l'unité électroluminescente (15a, 15b) et comprend une surface d'incidence de la lumière (23a) sur laquelle la lumière émise par l'unité électroluminescente (15a, 15b) est incidente,
dans lequel la section de guidage de la lumière (23) comprend une surface émettrice de lumière (23b) située à un emplacement faisant face à la section de commande (31) à l'opposé de la surface d'incidence de la lumière (23a),
**caractérisé en ce que**
un corps de base (21), qui est supporté au-dessus d'un substrat (11) par des éléments élastiques (13a, 13b) interposés, est fourni avec la section de commande (31) ;
la section de guidage de la lumière (23) est fixée à la section d'électrode (25),
la surface d'incidence de la lumière (23a) et la surface émettrice de lumière (23b) sont des surfaces planes, et
une zone de la surface émettrice de lumière (23b) est plus grande que celle de la surface d'incidence de la lumière (23a).

2. Le dispositif d'entrée (1) selon la revendication 1,
dans lequel la section de commande (31) est positionnée sur un côté de la section d'électrode (25) à l'opposé de l'unité électroluminescente (15a, 15b) de manière à faire face à l'ouverture (25c) et avec laquelle le corps de commande (60) entre en contact ou dont le corps de commande (60) s'approche,
dans lequel une surface intérieure d'une partie creuse de la section d'électrode (25) s'étend de l'ouverture (25c) vers l'unité électroluminescente (15a, 15b).

3. Le dispositif d'entrée (1) selon l'une quelconque des revendications 1 ou 2, comprenant en outre :
un commutateur (17),
dans lequel la section de commande (31) est déplacée dans une direction de pression dirigée vers l'unité électroluminescente (15a, 15b) selon la commande par pression, et effectue l'actionnement du commutateur (17) sur une position prédéterminée dans la direction de pression.

4. Le dispositif d'entrée (1) selon la revendication 3, comprenant en outre :
un élément élastique (13a, 13b) qui est configuré de manière à générer une force élastique dans la direction de la commande par pression de la section de commande (31),
dans lequel la section de commande (31) est déplacée dans la direction de pression contre la force élastique de l'élément élastique (13a, 13b) selon la commande par pression.

5. Le dispositif d'entrée (1) selon la revendication 4,
dans lequel la section d'électrode (25) est déplacée dans la direction de la commande par pression tout en s'enclenchant avec le mouvement de la section de commande (31) dans la direction de pression, et
une extrémité de l'élément élastique conducteur (13a, 13b) est fixée à la section d'électrode (25).

6. Le dispositif d'entrée (1) selon l'une quelconque des revendications 1 à 5,
dans lequel la section d'électrode (25) est en métal.
